# EUROPEAN PATENT APPLICATION

(11) **EP 4 254 262 A1**
(43) Date of publication of application: **04.10.2023**
(21) Application number: 21898491.2
(22) Date of filing: 18.11.2021
(51) Int. Cl.: G06K 9/62, G06T 7/00, G06N 20/00, H02S 50/10

(54) **METHOD AND APPARATUS FOR CLASSIFYING IMAGES OF SOLAR BATTERY CELLS**

(30) Priority: 24.11.2020 KR 20200158500
(71) Applicant: Hanwha Solutions Corporation, Jung-gu Seoul 04541 (KR)
(72) Inventor: SHIN, Kyoung Sup, Cheonan-si, Chungcheongnam-do 31168 (KR)
(74) Representative: Mooser, Sebastian Thomas
(86) International application number: PCT/KR2021/016953
(87) International publication number: WO 2022/114665

(57) **Abstract**

The present invention relates to a method and apparatus for classifying images of solar battery cells. The method according to an exemplary embodiment of the present invention is performed by an electronic apparatus, and is a method for determining whether a solar battery cell being inspected is defective, based on an electroluminescence (EL) image of the solar battery cell being inspected. The method comprises: a step of classifying an EL image of a solar battery cell being inspected, according to whether a black spot occupies a certain percentage or more of the EL image of the solar battery cell being inspected, namely, primarily classifying the EL image of the solar battery cell being inspected into a first type in which a black spot occupies a certain percentage or more, or a second type in which a black spot occupies less than the certain percentage; and a step of secondarily classifying the type of defect of the solar battery cell being inspected, based on the EL image of the solar battery cell being inspected, by using a pre-trained defect classification model, if the EL image of the solar battery cell being inspected is primarily classified into the first type.

## Description

### CROSS-REFERENCE TO RELATED APPLICATION

This application claims priority to and the benefit of Korean Patent Application No. 10-2020-0158500, filed on November 24, 2020, the disclosure of which is incorporated herein by reference in its entirety.

### [Technical Field]

The present invention relates to a method and apparatus for classifying an image for a solar battery cell, and more specifically to a method and apparatus for quickly and accurately classifying the defect and type of a solar battery cell based on an electroluminescence image (EL image) of the solar battery cell.

### [Background Art]

A solar battery cell is a device that converts incident sunlight into electrical energy and outputs the same. Since these solar battery cells use sunlight as an energy source, the replenishment of fuel is unnecessary, and they are widely used in power devices such as portable electronic calculators, electronic watches, outdoor clocks, broadcasting relay stations, communication satellites, broadcasting satellites and the like.

Conventionally, in order to inspect whether a solar battery cell is defective, the method of analyzing the current-voltage characteristic of a solar battery cell by irradiating light has been mainly used (hereinafter, referred to as the "related art"). However, in this related art, it is possible to inspect only some of various defects that are closely related to the lifetime of a solar battery cell (*e*.*g*., external cracks, internal cracks, reduced luminance, electrode defects, short circuits, junction breakdown, hot spots, *etc*.). That is, the related art has a problem in that it cannot be inspected for defects such as internal cracks that are invisible but generated during the process.

In addition, since the related art takes a considerable amount of time to inspect one solar battery cell, it is difficult to apply the same to a large number of mass-produced solar battery cells. That is, each solar battery cell has its own unique EL image, and for example, although it is necessary to analyze each unique EL image corresponding to 2 million or more per day, the related art is difficult to respond thereto.

### [Disclosure]

### [Technical Problem]

In order to solve the problems of the related art as described above, the present invention is directed to providing a method and apparatus for quickly and accurately classifying the defect and type of a solar battery cell based on an electroluminescence (EL) image of the solar battery cell.

However, the problems to be solved by the present invention are not limited to the problems mentioned above, and other problems that are not mentioned will be clearly understood by those of ordinary skill in the art to which the present invention pertains from the description below.

### [Technical Solution]

In order to solve the above-described problems, the method for determining whether a solar battery cell being inspected is defective, performed by an electronic apparatus and based on an electroluminescence image (EL image) of the solar battery cell being inspected according to an exemplary embodiment of the present invention includes a step of classifying an EL image of a solar battery cell being inspected, according to whether a black spot occupies a certain percentage or more of the EL image of the solar battery cell being inspected, namely, primarily classifying the EL image of the solar battery cell being inspected into a first type in which a black spot occupies a certain percentage or more, or a second type in which a black spot occupies less than the certain percentage; and a step of secondarily classifying the type of defect of the solar battery cell being inspected, based on the EL image of the solar battery cell being inspected, by using a pre-trained defect classification model, if the EL image of the solar battery cell being inspected is primarily classified into the first type.

The defect classification model may be a model which is trained according to a machine learning technique by using learning data that respectively includes input data for learning EL images and result data for the type of defect of the solar battery cell of the learning EL images.

The primarily classifying may include a step of classifying the EL image of the solar battery cell being inspected by using a pre-trained image generation model according to a machine learning technique to generate an image (black spot image) for a black spot included in the EL image from the learning EL images.

The image generation model may be a model which is trained by using learning data that respectively includes input data for learning EL images and result data for the black spot image according to image processing of the learning EL images.

The image processing may include histogram homogenization processing, bus-bar line removal processing, edge-based perspective transform processing and contour extraction processing for the learning EL images.

The defect classification model may classify the types of defects generated in a plurality of different manufacturing processes by a plurality of causes.

The classification apparatus according to an exemplary embodiment includes a memory for storing an EL image of a solar battery cell being inspected; and a control unit for processing the stored EL image of the solar battery cell being inspected and controlling to analyze whether the solar battery cell being inspected is defective, wherein the control unit classifies an EL image of a solar battery cell being inspected, according to whether a black spot occupies a certain percentage or more of the EL image of the solar battery cell being inspected, namely, primarily classifies the EL image of the solar battery cell being inspected into a first type in which a black spot occupies a certain percentage or more, or a second type in which a black spot occupies less than the certain percentage, and secondarily classifies the type of defect of the solar battery cell being inspected, based on the EL image of the solar battery cell being inspected, by using a pre-trained defect classification model, if the EL image of the solar battery cell being inspected is primarily classified into the first type.

The classification apparatus according to another exemplary embodiment of the present invention includes a communication unit for receiving an EL image of a solar battery cell being inspected; and a control unit for processing the received EL image of the solar battery cell being inspected and controlling to analyze whether the solar battery cell being inspected is defective, wherein the control unit classifies an EL image of a solar battery cell being inspected, according to whether a black spot occupies a certain percentage or more of the EL image of the solar battery cell being inspected, namely, primarily classifies the EL image of the solar battery cell being inspected into a first type in which a black spot occupies a certain percentage or more, or a second type in which a black spot occupies less than the certain percentage, and secondarily classifies the type of defect of the solar battery cell being inspected, based on the EL image of the solar battery cell being inspected, by using a pre-trained defect classification model, if the EL image of the solar battery cell being inspected is primarily classified into the first type.

The defect classification model may be a model which is trained according to a machine learning technique by using learning data that respectively includes input data for learning EL images and result data for the type of defect of the solar battery cell of the learning EL images.

The control unit may control the execution of an operating program, and the operating program may perform the analysis on the EL images of the solar battery cell being inspected according to time, date, cell ID or manufacturing line.

### [Advantageous Effects]

The present invention configured as described above has the advantage of being able to quickly and accurately classify the defect and type of a solar battery cell based on the EL image of a solar battery cell.

In addition, the present invention has the advantage of being able to minimize human error because it can be applied to the entire inspection of more than a million EL images per day.

The effects that can be obtained in the present invention are not limited to the above-mentioned effects, and other effects that are not mentioned will be clearly understood by those of ordinary skill in the art to which the present invention pertains from the following description.

### [Description of Drawings]

FIG. 1 shows a block diagram of the solar battery cell analysis system 10 according to an exemplary embodiment of the present invention.
FIG. 2 shows an example of a solar battery cell 400.
FIG. 3 shows a block diagram showing the classification apparatus 300 according to an exemplary embodiment of the present invention.
FIG. 4 shows a block diagram showing a control unit 350 in the classification apparatus 300 according to an exemplary embodiment of the present invention.
FIG. 5 shows a flowchart of the image classification method according to an exemplary embodiment of the present invention.
FIG. 6 shows an example of the operating program according to an exemplary embodiment of the present invention.
FIG. 7 shows each image in a process in which an EL image is image-processed for primarily classifying an EL image.
FIG. 8 shows various examples of EL images and black spot images derived for primarily classifying the EL image.
FIG. 9 shows an example of a defect classification model.
FIG. 10 shows various examples of the types of black spots in EL images.
FIG. 11 shows various examples of classification results by using an actually implemented defect classification model.

### [Modes of the Invention]

The above-described objects and means of the present invention and the effects associated therewith will become more apparent through the following detailed description in conjunction with the accompanying drawings. Accordingly, those skilled in the art to which the present invention pertains can readily implement the technical spirit of the present invention. In addition, when it is determined that the detailed descriptions of related well-known functions unnecessarily obscure the gist of the present invention during the description of the present invention, the detailed descriptions thereof will be omitted.

Terms used herein are for the purpose of describing exemplary embodiments only and are not intended to limit the present invention. In the present specification, the singular forms are intended to include the plural forms as well in some cases, unless the context clearly indicates otherwise. In the present specification, terms such as "comprises," "comprising," "includes," "including," "has" and/or "having," do not preclude the presence or addition of one or more other components other than the components mentioned.

In the present specification, terms such as "or,", "at least one" and the like may represent one of the words listed together or may represent a combination of two or more. For example, "A or B" and "at least one of A and B" may include only one of A or B, and may include both A and B.

In the present specification, descriptions following "for example" may not exactly match the information presented, such as cited characteristics, variables or values, and the exemplary embodiments of the present invention according to various examples of the present invention should not be limited by effects such as modifications including the limits of tolerances, measurement errors and measurement accuracy, and other commonly known factors.

In the present specification, when it is described that one component is "connected" or "joined" to another component, it should be understood that the one component may be directly connected or joined to another component but an additional component may be present therebetween. However, when one component is described as being "directly connected" or "directly coupled" to another component, it should be understood that the additional component may be absent between the one component and another component.

In the present specification, when one component is described as being "on" or "facing" another component, it should be understood that the one component may be directly in contact with or connected to another component, but additional component may be present between the one component and another component. However, when one component is described as being "directly on" or "in direct contact with" another component, it should be understood that there is no additional component between the one component and another component. Other expressions describing the relationship between components, such̃ as "between~," "directly between ~" and the like should be interpreted in the same waỹ.

In the present specification, terms such as "first" and "second" may be used to describe various components, but the components should not be limited by the above terms. In addition, the above terms should not be interpreted as limiting the order of each component but may be used for the purpose of distinguishing one component from another. For example, a "first element" could be termed a "second element", and similarly, a "second element" could also be termed a "first element".

Unless defined otherwise, all terms used herein may be used in a sense commonly understood by those skilled in the art to which the present invention pertains. In addition, it should be understood that terms, such as those defined in commonly used dictionaries, will not be interpreted in an idealized or overly formal sense unless expressly so defined herein.

Hereinafter, a preferred exemplary embodiment according to the present invention will be described in detail with reference to the accompanying drawings.

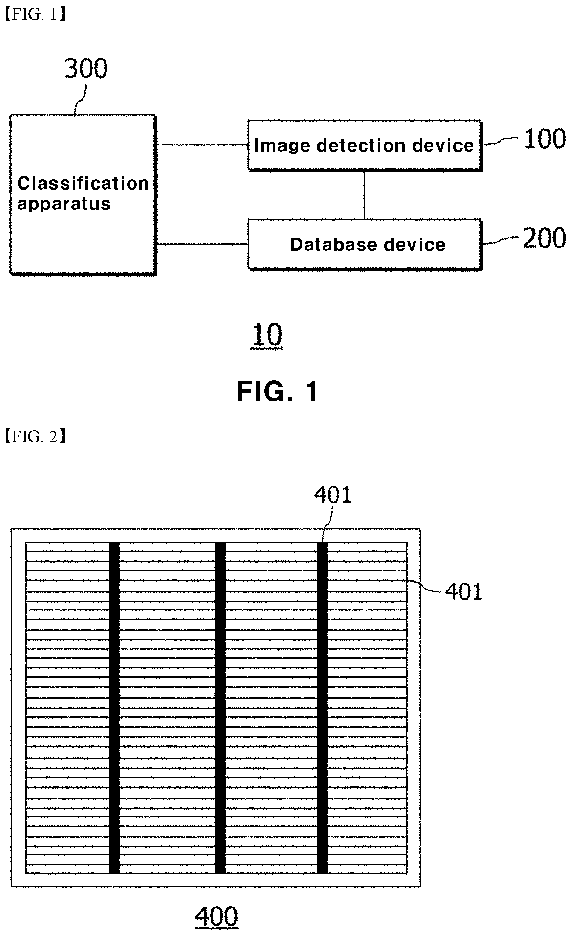

FIG. 1 shows a block diagram of the solar battery cell analysis system 10 according to an exemplary embodiment of the present invention, and FIG. 2 shows an example of a solar battery cell 400.

The solar battery cell analysis system 10 according to an exemplary embodiment of the present invention is a system for analyzing and managing whether a solar battery cell manufactured through various processes is defective and the type of the defect. As illustrated in FIG. 1, the solar battery cell analysis system 10 may include an image detection device 100, a database device 200 and a classification apparatus 300. In this case, data may be transmitted/received between the image detection device 100, the database device 200 and the classification apparatus 300 through various wired/wireless communication methods.

Referring to FIG. 2, the solar battery cell 400 includes a plurality of finger bars 401 and bus-bars 402 which are thin strips treated with thin metallization on the front surface thereof. These finger bars 401 and bus-bars 402 are passages through which electrons (photoelectric effect) generated by sunlight move by electromotive force (photovoltaic effect), and correspond to electrodes.

A plurality of finger bars 401 may be disposed on the front surface of the solar battery cell 400 to be spaced apart from each other by a predetermined distance. In addition, the bus-bar 402 may be disposed to cross the front surface of the solar battery cell 400 in a horizontal direction or a vertical direction. That is, the bus-bar 402 may extend in a direction crossing or orthogonal to the extending direction of the finger bar 401 and may be disposed to be spaced apart from each other, and connect the finger bars 401 that are formed on the front surface of the solar battery cell 400. In this case, the plurality of finger bars 401 are connected to the bus-bar 402, and the generated current is collected and transmitted to the bus-bar 402. The bus-bar 402 may be continuously formed to have a constant width or may be formed discontinuously.

For example, the very thin finger bars 401 may be disposed in a horizontal direction, and the bus-bars 402 may be disposed in a vertical direction. In addition, the solar battery cell module including a plurality of solar battery cells 400 may be connected between the solar battery cells through bus-bars.

The image detection device 100 is a device for detecting an image of a solar battery cell being inspected. In particular, the image detection device 100 may detect an electroluminescence image (EL image) of a solar battery cell through an electroluminescence camera. For example, the image detection device 100 may generate an EL image by photographing EL light emitted from a solar battery cell to which the power of a forward current or a reverse voltage is applied. In addition, power is applied in units of solar battery cell modules, and an EL image according to EL light emitted from each solar battery cell may be detected.

The database device 200 stores and manages a database including various data processed for the operation of the solar battery cell analysis system 10. In this case, the database may include the data of EL images detected by the image detection device 100. That is, the database device 200 may receive the data of EL images detected by the image detection device 100 from the image detection device 100 and store and manage the data in the database. In addition, the database may include the data of classification results for the EL images analyzed by the classification apparatus 300. That is, the database device 200 may receive the classification result data from the classification apparatus 300 and store and manage the data in the database.

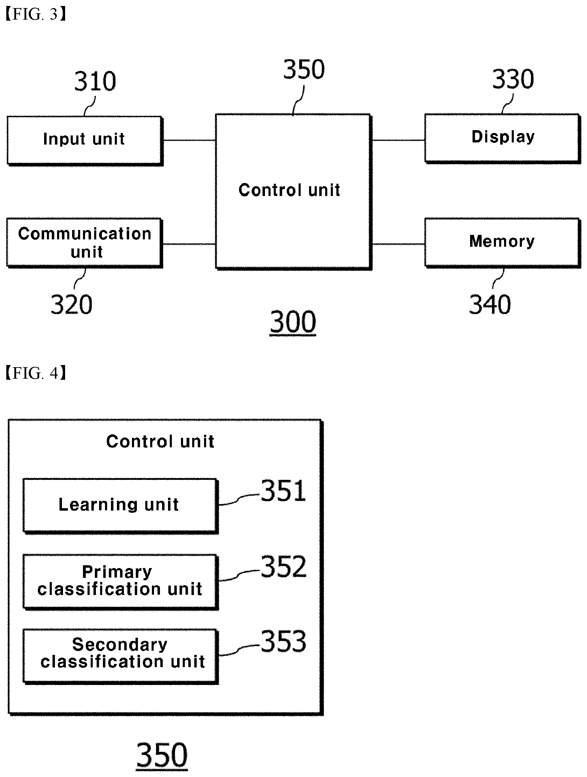

FIG. 3 shows a block diagram showing the classification apparatus 300 according to an exemplary embodiment of the present invention.

The classification apparatus 300 is an apparatus for classifying whether a solar battery cell being inspected is defective based on the data of EL images, and it may be an electronic device or a computing network which is capable of computing. In this case, the EL image may be detected by the detection apparatus 100 or may be separately received by another apparatus.

For example, examples of the electronic device include a desktop personal computer (PC), a laptop personal computer (PC), a tablet personal computer (PC), a netbook computer, a workstation, a personal digital assistant (PDA), a smartphone, a smart pad, a mobile phone and the like, but the present invention is not limited thereto.

As illustrated in FIG. 3, the classification apparatus 300 may include an input unit 310, a communication unit 320, a display 330, a memory 340 and a control unit 350.

The input unit 310 generates input data in response to the input of various users (monitor, *etc.*), and may include various input means. For example, the input unit 310 may transmit an input for various selections according to the execution of the operating program from the user to the control unit 350. For example, the input unit 310 may include a keyboard, a keypad, a dome switch, a touch panel, a touch key, a touch pad, a mouse, a menu button and the like, but the present invention is not limited thereto.

The communication unit 320 is configured to communicate with other devices. For example, the communication unit 320 is receiving EL image data from the image detection device 100, the database device 200 or another apparatus. In addition, the communication unit 320 may transmit the data of classification results for the EL image performed under the control of the control unit 350 to the database device 200 or another device. For example, the communication unit 320 may perform wireless communication such as 5^{th} generation communication (5G), long term evolution-advanced (LTE-A), long term evolution (LTE), Bluetooth, Bluetooth Low Energy (BLE), near field communication (NFC), Wi-Fi communication and the like, or wired communication such as cable communication and the like, but the present invention is not limited thereto.

The display 330 displays various image data on a screen, and may be configured as a non-emissive panel or a light emitting panel. For example, the display 330 may display an EL image, a blackspot image, an execution screen of an operating program and the like. For example, examples of the display 330 may include a liquid crystal display (LCD), a light emitting diode (LED) display, an organic light emitting diode (OLED) display, a micro-electromechanical systems (MEMS) display, an electronic paper display and the like, but the present invention is not limited thereto. In addition, the display 330 may be implemented as a touch screen or the like in combination with the input unit 310.

The memory 340 stores various types of information necessary for the operation of the classification apparatus 300. For example, the storage information may include an EL image, a black spot image, an image generation model, a defect classification model, program information related to an image classification method to be described below and the like. In addition, the memory 340 may store the above-described database. For example, the memory 340 may be a hard disk type, a magnetic media type, a compact disc read-only memory (CD-ROM), an optical media type, a magneto-optical media type, a multimedia card micro type, a flash memory type, a read-only memory type, a random access memory type or the like, but the present invention is not limited thereto. In addition, the memory 340 may be a cache, a buffer, a main memory, an auxiliary memory or a separately provided storage system according to its purpose/location, but the present invention is not limited thereto.

The control unit 350 may perform various control operations of the classification apparatus 300. That is, the control unit 350 may control the execution of an image classification method to be described below, and may control the operations of the remaining components of the classification apparatus 300, that is, the input unit 310, the communication unit 320, the display 330, the memory 340 and the like. For example, the control unit 350 may include a processor which is hardware or a process which is software that is executed in the processor, and the processor may be a processing unit such as a graphic processing unit (GPU), a central processing unit (CPU), a microprocessor unit (MPU), a micro controller unit (MCU) or the like, but the present invention is not limited thereto.

FIG. 4 shows a block diagram showing a control unit 350 in the classification apparatus 300 according to an exemplary embodiment of the present invention.

The control unit 350 controls the execution of the image classification method according to an exemplary embodiment of the present invention, and as illustrated in FIG. 4, it may include a learning unit 351, a primary classification unit 352 and a secondary classification unit 353. For example, the learning unit 351, the primary classification unit 352 and the secondary classification unit 353 may be hardware configurations of the control unit 350 or software processes that are executed in the control unit 350, but the present invention is not limited thereto.

Hereinafter, the image classification method according to the present invention will be described in more detail.

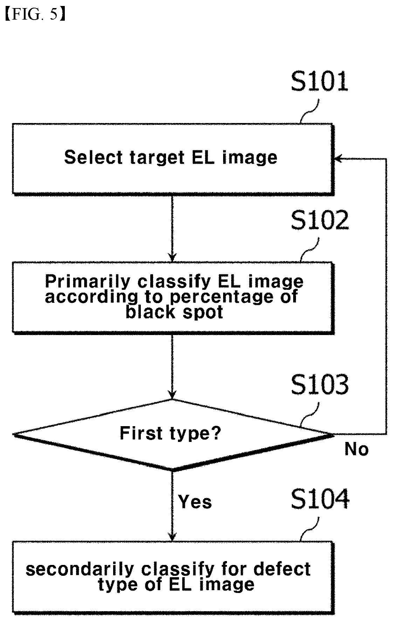

FIG. 5 shows a flowchart of the image classification method according to an exemplary embodiment of the present invention.

The image classification method according to an exemplary embodiment of the present invention is a method for classifying whether a solar battery cell being inspected is defective based on an EL image, and it may include steps S 101 to S104 as illustrated in FIG. 5.

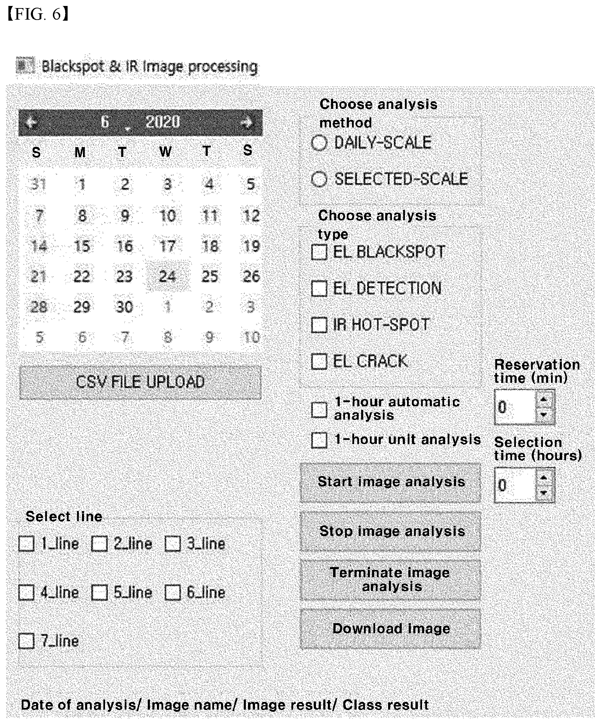

FIG. 6 shows an example of the operating program according to an exemplary embodiment of the present invention.

S101 is a step of selecting an EL image (hereinafter, referred to as a "target EL image") of a solar battery cell being inspected. That is, in S101, the control unit 350 may control the execution of an operating program as shown in FIG. 6 for the analysis of classification of a target EL image, and the target EL image may be selected according to an input command which is selected and input by the user in the executed operating program.

That is, in addition to the data of the EL image, the target EL image may store ID (identification; unique identification information) data of the solar battery cell being inspected, and data on the date, time and manufacturing line of the solar battery cell being inspected together in the database of a database device 200 or a memory 340. Accordingly, in S101, the user may select a desired target EL image according to the corresponding time, date, cell ID or manufacturing line through the operating program.

For example, referring to FIG. 6, for the target EL image, depending on the selected date, it is possible to perform a daily (DAILY-SCALE) batch analysis, a time unit (SELECTED-SCALE) batch analysis or a cell ID selection analysis. In addition, analysis according to the selection of a desired line (line selection) is also possible. In addition, for the analysis of the target EL image, it is also possible to select 1-hour automatic execution/manual execution (1-hour automatic analysis/1-hour unit analysis).

S 102 is a step of primarily classifying the target EL image according to whether a black spot, which is a dark portion of the selected target EL image, occupies a certain percentage or more. That is, the efficiency of the solar battery cell is correlated with the percentage of black spots, and when the percentage of the black spots is greater than or equal to a certain level, the efficiency of the solar battery cell may rapidly deteriorate. S102 is a step of first performing classification according to the percentage of black spots by reflecting these contents.

In S102, if the black spot occupies a certain percentage (*e*.*g*., 1.5% or more) in the target EL image, the primary classification unit 352 may classify the target EL image as a first type (*e*.*g*., it classifies the black spot as True). On the other hand, when the black spot occupies less than a certain level (*e*.*g*., less than 1.5%) in the target EL image, the primary classification unit 352 may classify the target EL image as a second type (*e*.*g*., it classifies the black spot as False).

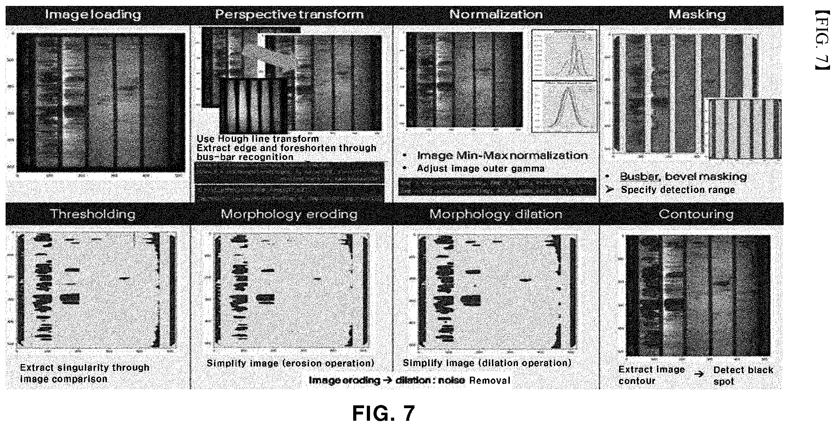

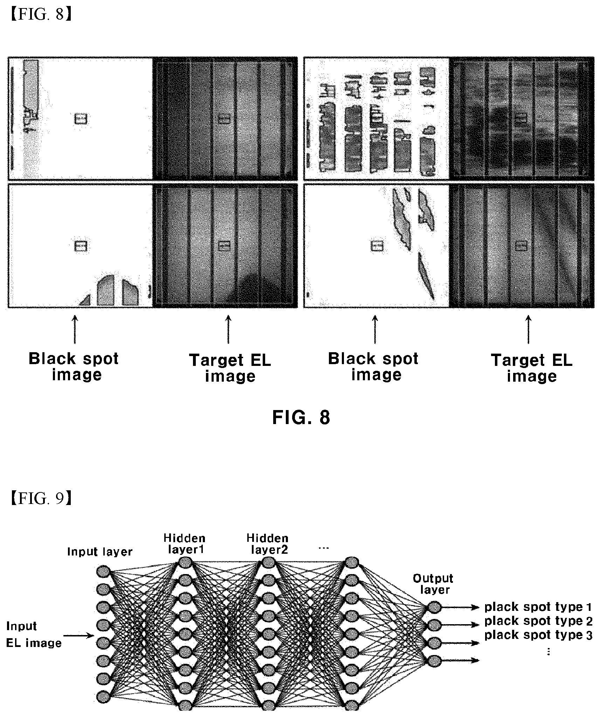

FIG. 7 shows each image in a process in which an EL image is image-processed for primarily classifying an EL image, and FIG. 8 shows various examples of EL images and black spot images derived for primarily classifying the EL image.

In particular, in S102, the primary classification unit 352 may primary classify the target EL image by using an image generation model. That is, the image generation model is a model which is trained according to an unsupervised learning method machine learning technique in order to generate an image (black spot image) for a black spot included in the EL image from learning EL images.

For example, the unsupervised learning method may be an auto-encoder, a variant auto-encoder, a generative adversarial network or the like, but the present invention is not limited thereto.

For example, the image generation model is trained through learning data of a pair of input data and output data, and it includes a plurality of layers and has a function of the relationship between input data and output data. In this case, the input data may include the data of learning EL images, and the result data may include the data of black spot images according to image processing for the learning EL images. Accordingly, the image generation model may output the data of a black spot image for the target EL image when the data of a target EL image is input.

Specifically, referring to FIG. 7, for image processing for EL images, with regard to learning EL images, histogram homogenization processing, bus-bar line removal processing, edge extraction processing, perspective transform processing based on the extracted edges, contour extraction processing and the like may be performed.

In this case, the histogram homogenization process is an image processing for normalizing the range of the luminance values of an EL image to a predetermined range. That is, this is to perform different image processing under the same luminance range condition by scaling the range of luminance values of the EL images having various ranges according to a predetermined criterion.

The bus-bar line removal processing is an image processing for removing a bus-bar line which is is a range corresponding to a bus-bar from the EL image. This is to enable more accurate black spot detection by removing the bus-bar line from the EL image since the bus-bar line corresponds to a region where black spots do not occur.

The edge extraction processing is an image processing for extracting an edge which is each corner point in the EL image. Since it has various image angles (*e*.*g*., the shape of the solar cell in the EL image is not exactly rectangular and has a distorted angle, *etc.*), for matching therefor, this is to extract an edge serving as a reference point for the matching.

The projection transformation processing is an image processing for projecting the transformation of an EL image based on an edge extracted according to the edge extraction processing in order to match an EL image at various image angles into an EL image at a constant angle. For example, the projection conversion processing may project and convert an EL image having the shape of a solar battery cell in a distorted form into an EL image having the shape of a solar battery cell in the form of a rectangle.

The contour extraction processing is a processing for extracting the contours of various regions existing in the EL image in order to extract black spots from the EL image subjected to various image processing.

For example, the above-described image processing on the EL image may be performed in the order of histogram homogenization processing, bus-bar line removal processing, edge extraction processing, projection transformation processing based on the extracted edge and contour extraction processing, but the present invention is not limited thereto, and the above-described image processing may be performed in a different order. However, the contour extraction processing may correspond to the last stage among the above-described image processing.

Meanwhile, the images processed according to these image processing may be separately generated by using a model which is trained according to an unsupervised learning method. That is, the histogram homogenization processing model, the bus-bar line removal processing model, the edge extraction processing model, the projection transformation processing model and the contour extraction processing model may be separately trained and prepared. In this case, the image generation model may be referred to as a model including all of these models. Alternatively, the image generation model may include a plurality of layers that sequentially perform these image processing.

This image generation model may be pre-trained by the learning unit 351 or may be pre-trained in another device and transmitted to the classification apparatus 300 through the communication unit 320.

In S102, the primary classification unit 352 may calculate a percentage of black spots that are generated by the image generation model and occupy in the corresponding EL image, and it is possible to classify whether the corresponding EL image is a first type or a second type according to the calculation result.

In S103, the control unit 350 determines whether the EL image which is primarily classified in S102 is a first type. In this case, if it is the first type, it corresponds to a case with a black spot in a poor state of solar battery cell efficiency, and thus, for the cell of the corresponding solar battery cell, S104 is performed to further classify the black spot type (*i.e.,* the type of defect) in more detail. On the other hand, if it is not the first type, it corresponds to a case with a black spot in a state where the solar battery cell efficiency is good, and thus, it is no longer necessary to classify the type of the black spot in detail for the cell of the corresponding solar battery cell, and it is possible to return to S101 and receive the input of a selection for another target EL image.

S104 is a step of secondarily classifying the defect type of the target EL image, which is the first type (*i*.*e*., the type of the black spot). That is, depending on the shape of a black spot in the EL image, various defects of the solar battery cell may be divided, and S104 is a step of classifying the type of the defect by reflecting these contents.

Particularly, in S104, the secondary classification unit 352 may secondarily classify the defective type of the solar battery cell being inspected, based on the target EL image by using the pre-trained defect classification model.

For example, the defect classification model is trained by a supervised learning method machine learning method through the learning data of a pair of input data and output data, and by including multiple layers, it has a function for the relationship between input data and output data.

For example, the defect classification model may be a model which is trained according to a deep learning technique, and examples of the deep learning technique may include a Deep Neural Network (DNN), Convolutional Neural Network (CNN), Recurrent Neural Network (RNN), Restricted Boltzmann Machine (RBM), Deep Belief Network (DBN), Deep Q-Networks and the like, but the present invention is not limited thereto.

FIG. 9 shows an example of a defect classification model.

Referring to FIG. 9, the defect classification model may express the relationship between input data and output data as multiple hidden layers between the input layer and the output layer. In this case, each hidden layer consists of at least one filter, and each filter has a matrix of weights. That is, each element (pixel) in the matrix of the corresponding filter may correspond to a weight value.

That is, in the learning data for the defect classification model, the input data may include the data of learning EL images. In addition, the output data may include the data of defect types for the solar battery cell of the learning EL images, which are data having labels. Accordingly, when the data of a target EL image is input, the defect classification model may output the data of defect types (*i*.*e*., the type of a black spot) for the target EL image. In this case, the learning EL image may be an image of the first type, that is, an image in which black spots occupy a certain percentage or more in the EL image.

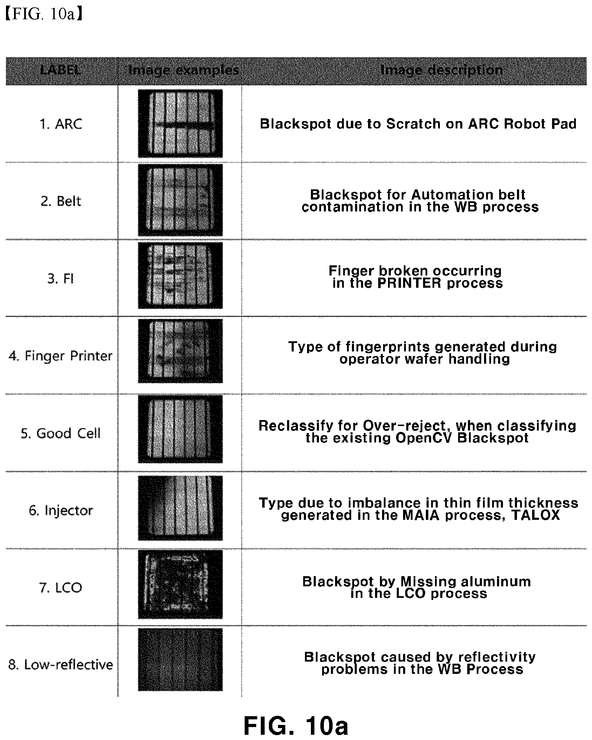

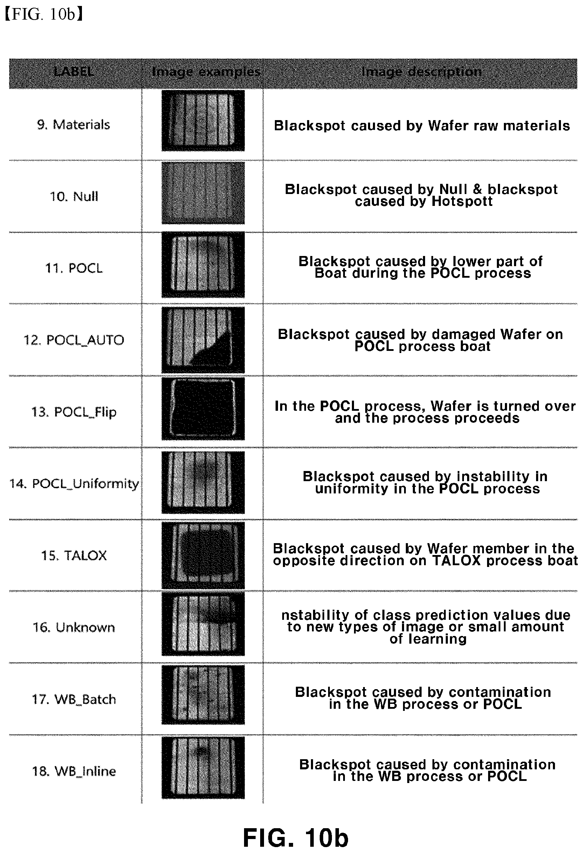

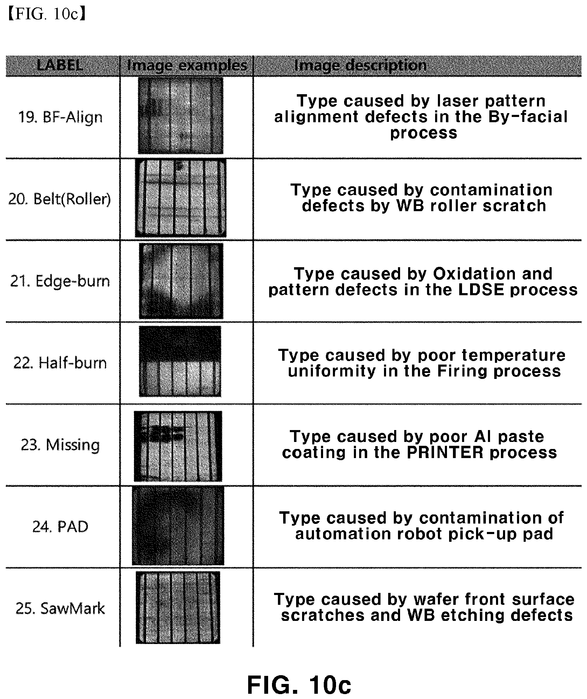

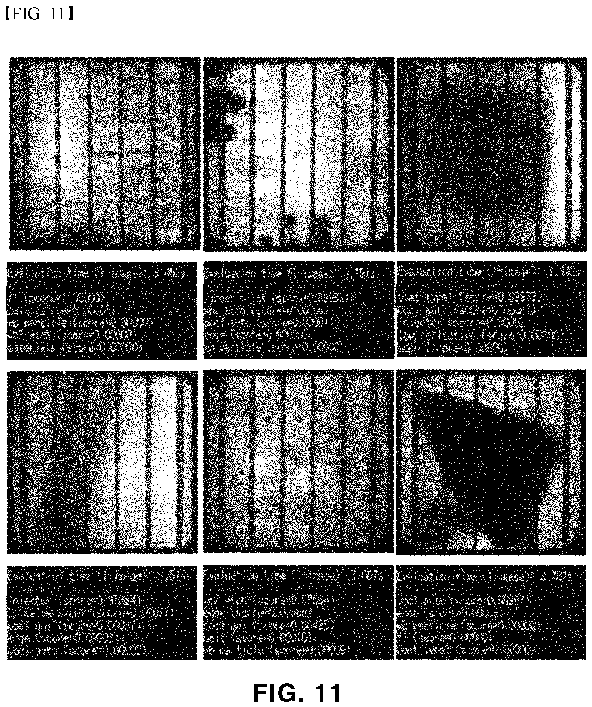

FIG. 10 shows various examples of the types of black spots in EL images, and FIG. 11 shows various examples of classification results by using an actually implemented defect classification model.

Referring to FIG. 10, the defect classification model may classify the defect type (*i*.*e*., the type of a black spot) which is generated in a plurality of different manufacturing processes (*i*.*e*., the manufacturing process of a solar battery cell) due to a plurality of causes for a target EL image which is input. For example, the type of a black spot may include the following various types, but the present invention is not limited thereto.
- Type 1: Type caused by a scratch on the ARC Robot Pad
- Type 2: Type caused by WB Process Automation belt contamination
- Type 3: Type caused by finger broken in the printer process
- Type 4: Type caused by fingerprints generated during wafer handling by the operator
- Type 5: Type of reclassification for over-reject, when classifying the existing OpenCV black spot type
- Type 6: Type caused by thin film thickness imbalance caused by Talox in the MAIA process
- Type 7: Type caused by missing aluminum in the LCO process
- Type 8: Type caused by the problem of reflective slaughter in the WB process
- Type 9: Type caused by the problem with raw materials of the wafer itself
- Type 10: Type caused by Null and Hotspot
- Type 11: Type caused by the lower part of a boat during the POCL process
- Type 12: Type caused by a broken wafer on a POCL process boat
- Type 13: Type generated as the process proceeded with the wafer turned upside down in the POCL process,
- Type 14: Type caused by unstable uniformity in the POCL process
- Type 15: Type caused by the absence of a wafer in the opposite direction on a TALOX process boat
- Type 16: Type that occurs because the prediction value of the defect classification model is unstable due to a new type of image or a small amount of learning
- Types 17 and 18: Types caused by contamination in the WB process or the POCL process
- Type 19: Type caused by defective laser pattern alignment in the by-facial process
- Type 20: Type caused by pollution defect due to WB roller scratch
- Type 21: Type caused by oxidation and defective pattern in the LDSE process
- Type 22: Type caused by poor firing process temperature uniformity
- Type 23: Type caused by poor application of Al paste in the PRINTER process
- Type 24: Type caused by contamination of the automation robot pick-up pad
- Type 25: Type caused by wafer front side scratches and WB etching defects

Meanwhile, the defect classification model is a model with the function of image classification, and it has very different characteristics from the model with the function of image augmentation. For example, in the case of an image augmentation model, it may have functions to check [the location of defect], [size] and [type] for an EL image of the solar battery cell module. However, the image augmentation model has a very complicated structure of the hidden layer, and thus, the amount of computation, computation time and storage capacity are very large, and moreover, when determining [the type of defect], there is a problem in that the conclusion about a vector value (i.e., representative value) of the EL image is very ambiguous. In contrast, since the defect classification model can check the [type of defect] for an EL image of the solar battery cell according to the simple and clear function of image classification, the amount of computation, computation time and storage capacity are very small compared to the image augmentation model, and further, there is an advantage in that the conclusion about the representative value is very clear.

Further, in S104, the secondary classification unit 353 may control to store the data of results of performing the above-described secondary classification in the memory 340 or the database of the database device 200. For example, the result data stored in the database may include the name of the EL image for which the primary and secondary classification have been performed, the shooting time, detailed information on the classification result (the percentage of black spots in the primary classification, the defect type which is the classification result in the secondary classification, *etc*.) and the like.

The above-described image classification method may be executed by being loaded into the memory 340 and executing a program under the control of the control unit 350. Such a program may be stored in the memory 340 of various types of non-transitory computer readable media. Non-transitory computer-readable media include various types of tangible storage media.

For example, non-transitory computer-readable media include magnetic recording media (*e*.*g*., flexible disks, magnetic tapes, hard disk drives), magneto-optical recording media (*e*.*g*., magneto-optical disks), CD-ROMs (read-only memory), CD-R, CD-R/W, semiconductor memory (*e*.*g*., mask ROM, programmable ROM (PROM), erasable PROM (EPROM), flash ROM, random access memory (RAM)), but the present invention is not limited thereto.

In addition, the program may be supplied by various types of transitory computer readable media. For example, the transitory computer-readable media may include an electrical signal, an optical signal and an electromagnetic wave, but the present invention is not limited thereto. That is, the temporary computer-readable media may supply the program to the control unit 350 through a wired communication path such as an electric wire or optical fiber, or a wireless communication path.

The present invention configured as described above has the advantage of being able to quickly and accurately classify the defect and type of a solar battery cell based on the EL image of the solar battery cell. For example, the present invention has an advantage in that it is possible to minimize human error since it can be applied to a total inspection of more than several million (*e*.*g*., 2 million) EL images per day.

While specific exemplary embodiments have been described in the detailed description of the present invention, various modifications may be made without departing from the scope of the present invention. Therefore, the scope of the present invention is defined not by the described exemplary embodiments but by the appended claims, and encompasses equivalents that fall within the scope of the appended claims.

### [Industrial Applicability]

The present invention can provide an image classification method and apparatus for a solar battery cell for quickly and accurately classifying the defect and type of a solar battery cell based on an electroluminescence (EL) image of the solar battery cell, and thus has industrial applicability.

## Claims

1. A method for determining whether a solar battery cell being inspected is defective, performed by an electronic apparatus and based on an electroluminescence (EL) image of the solar battery cell being inspected, comprising:
a step of classifying an EL image of a solar battery cell being inspected, according to whether a black spot occupies a certain percentage or more of the EL image of the solar battery cell being inspected, namely, primarily classifying the EL image of the solar battery cell being inspected into a first type in which a black spot occupies a certain percentage or more, or a second type in which a black spot occupies less than the certain percentage; and
a step of secondarily classifying the type of defect of the solar battery cell being inspected, based on the EL image of the solar battery cell being inspected, by using a pre-trained defect classification model, if the EL image of the solar battery cell being inspected is primarily classified into the first type,
wherein the defect classification model is a model which is trained according to a machine learning technique by using learning data that respectively includes input data for learning EL images and result data for the type of defect of the solar battery cell of the learning EL images.

2. The method of claim 1, wherein the primarily classifying comprises a step of classifying the EL image of the solar battery cell being inspected by using a pre-trained image generation model according to a machine learning technique to generate an image (black spot image) for a black spot included in the EL image from the learning EL images.

3. The method of claim 2, wherein the image generation model is a model which is trained by using learning data that respectively includes input data for learning EL images and result data for the black spot image according to image processing of the learning EL images.

4. The method of claim 3, wherein the image processing includes histogram homogenization processing, bus-bar line removal processing, edge-based perspective transform processing and contour extraction processing for the learning EL images.

5. The method of claim 1, wherein the defect classification model classifies the types of defects generated in a plurality of different manufacturing processes by a plurality of causes.

6. An apparatus, comprising:
a memory for storing an EL image of a solar battery cell being inspected; and
a control unit for processing the stored EL image of the solar battery cell being inspected and controlling to analyze whether the solar battery cell being inspected is defective,
wherein the control unit classifies an EL image of a solar battery cell being inspected, according to whether a black spot occupies a certain percentage or more of the EL image of the solar battery cell being inspected, namely, primarily classifies the EL image of the solar battery cell being inspected into a first type in which a black spot occupies a certain percentage or more, or a second type in which a black spot occupies less than the certain percentage, and secondarily classifies the type of defect of the solar battery cell being inspected, based on the EL image of the solar battery cell being inspected, by using a pre-trained defect classification model, if the EL image of the solar battery cell being inspected is primarily classified into the first type, and
wherein the defect classification model is a model which is trained according to a machine learning technique by using learning data that respectively includes input data for learning EL images and result data for the type of defect of the solar battery cell of the learning EL images.

7. An apparatus, comprising:
a communication unit for receiving an EL image of a solar battery cell being inspected; and
a control unit for processing the received EL image of the solar battery cell being inspected and controlling to analyze whether the solar battery cell being inspected is defective,
wherein the control unit classifies an EL image of a solar battery cell being inspected, according to whether a black spot occupies a certain percentage or more of the EL image of the solar battery cell being inspected, namely, primarily classifies the EL image of the solar battery cell being inspected into a first type in which a black spot occupies a certain percentage or more, or a second type in which a black spot occupies less than the certain percentage, and secondarily classifies the type of defect of the solar battery cell being inspected, based on the EL image of the solar battery cell being inspected, by using a pre-trained defect classification model, if the EL image of the solar battery cell being inspected is primarily classified into the first type, and
wherein the defect classification model is a model which is trained according to a machine learning technique by using learning data that respectively includes input data for learning EL images and result data for the type of defect of the solar battery cell of the learning EL images.

8. The apparatus of claim 6 or 7, wherein the control unit controls the execution of an operating program, and
wherein the operating program performs the analysis on the EL images of the solar battery cell being inspected according to time, date, cell ID or manufacturing line.
